# DEMANDE DE BREVET EUROPEEN

(11) **EP 2 315 243 A1**
(43) Date de publication de la demande: **27.04.2011**
(21) Numéro de dépôt: 10188606.7
(22) Date de dépôt: 22.10.2010
(51) Int. Cl.: H01L 23/38, H01L 25/065

(54) **Plaque d'interface entre circuits intégrés**

(30) Priorité: 23.10.2009 FR 0957445
(71) Demandeur: STmicroelectronics SA, 92120 Montrouge (FR)
(72) Inventeur: Felk, Yacine, 38000 Grenoble (FR); Farcy, Alexis, 73490 La Ravoire (FR)
(74) Mandataire: de Beaumont, Michel

(57) **Abrégé**

L'invention concerne une plaque d'interface (66) adaptée à être montée entre des première et deuxième puces électroniques (62, 64) à montage en surface. La plaque comprend une pluralité de premières (30), deuxièmes (80) et troisièmes ouvertures (82) traversantes, les premières ouvertures étant remplies d'un matériau conducteur et étant disposées pour, lors du montage, être en regard de plots (10, 16) des première et deuxième puces, les deuxièmes ouvertures étant remplies d'un deuxième matériau, les troisièmes ouvertures étant remplies d'un troisième matériau, les deuxième et troisième matériaux constituant deux composants complémentaires d'un couple thermoélectrique (92).

## Description

### Domaine de l'invention

La présente invention concerne l'assemblage de puces électroniques les unes sur les autres pour la réalisation de structures dites à intégration tridimensionnelle.

### Exposé de l'art antérieur

De façon générale, un système électronique comprend plusieurs puces électroniques, par exemple des processeurs et des mémoires. Pour connecter ces puces, il est usuel de monter ces puces sur un même substrat et de raccorder chacune des puces au substrat.

Pour réduire la surface occupée et fiabiliser le montage, on a prévu des structures dites tridimensionnelles, dans lesquelles une première puce à montage en surface est montée directement sur une deuxième puce à laquelle elle est connectée.

Chacune des deux puces pouvant être associée à un substrat différent, par exemple en verre, en silicium ou en arséniure de gallium, le raccordement des deux puces est rendu difficile. En effet, les puces peuvent avoir des propriétés mécaniques différentes. En outre, les plots de connexion des deux puces peuvent être dimensionnés différemment. Le raccordement électrique entre ces deux puces est donc rendu difficile.

Par ailleurs, l'augmentation de la densité de transistors dans un circuit ainsi que l'augmentation des fréquences de commutation des transistors engendrent l'apparition de points chauds dans les puces. Les flux thermiques peuvent être supérieurs à 300 W/cm². Si un point chaud se déclare dans la première puce, le rayonnement thermique sur la deuxième puce peut détériorer celle-ci.

### Résumé

Un objet d'un mode de réalisation de la présente invention est de prévoir un assemblage tridimensionnel de puces électroniques évitant aux moins certains des inconvénients des assemblages antérieurs.

Un objet plus particulier d'un mode de réalisation de la présente invention est d'éviter les influences néfastes du rayonnement thermique d'une puce sur une autre.

Un autre objet d'un mode de réalisation de la présente invention est de transformer en énergie électrique au moins une partie de la chaleur rayonnée par une puce.

Un autre objet d'un mode de réalisation de la présente invention est de prévoir un assemblage tridimensionnel d'épaisseur réduite.

Ainsi, un mode de réalisation de la présente invention prévoit une plaque d'interface adaptée à être montée entre des première et deuxième puces électroniques à montage en surface, cette plaque comprenant une pluralité de premières, deuxièmes et troisièmes ouvertures traversantes, les premières ouvertures étant remplies d'un matériau conducteur et étant disposées pour, lors du montage, être en regard de plots des première et deuxième puces, les deuxièmes ouvertures étant remplies d'un deuxième matériau, les troisièmes ouvertures étant remplies d'un troisième matériau, les deuxième et troisième matériaux constituant deux composants complémentaires d'un couple thermoélectrique.

Selon un autre mode de réalisation de la présente invention, le deuxième ou le troisième matériau est identique au matériau conducteur.

Selon un autre mode de réalisation de la présente invention, le deuxième et le troisième matériau sont compris dans le groupe comprenant le silicium, le germanium, le cuivre, le tungstène et l'aluminium.

Selon un autre mode de réalisation de la présente invention, la plaque d'interface comprend au moins un ensemble de premiers couples thermoélectriques coopérant avec la première puce, les premiers couples étant connectés en série.

Selon un autre mode de réalisation de la présente invention, la plaque d'interface comprend au moins un deuxième ensemble de deuxièmes couples thermoélectriques coopérant avec la deuxième puce, les deuxièmes couples étant connectés en série entre eux et n'étant pas connectés en série avec les premiers couples.

Un autre mode de réalisation de la présente invention prévoit un dispositif électronique comprenant :
une première puce électronique à montage en surface,
une deuxième puce électronique à montage en surface,
une plaque d'interface telle que décrite ci-dessus de part et d'autre de laquelle sont montées les première et deuxième puces.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une vue schématique en coupe d'un dispositif électronique comprenant deux puces connectées entre elles par une plaque d'interface ;
la figure 2 est une vue schématique en coupe d'un dispositif électronique, selon un mode de réalisation de la présente invention ; et
les figures 3A à 3E sont des vues schématiques en coupe illustrant un procédé de fabrication d'une plaque d'interface, selon un mode de réalisation de la présente invention.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

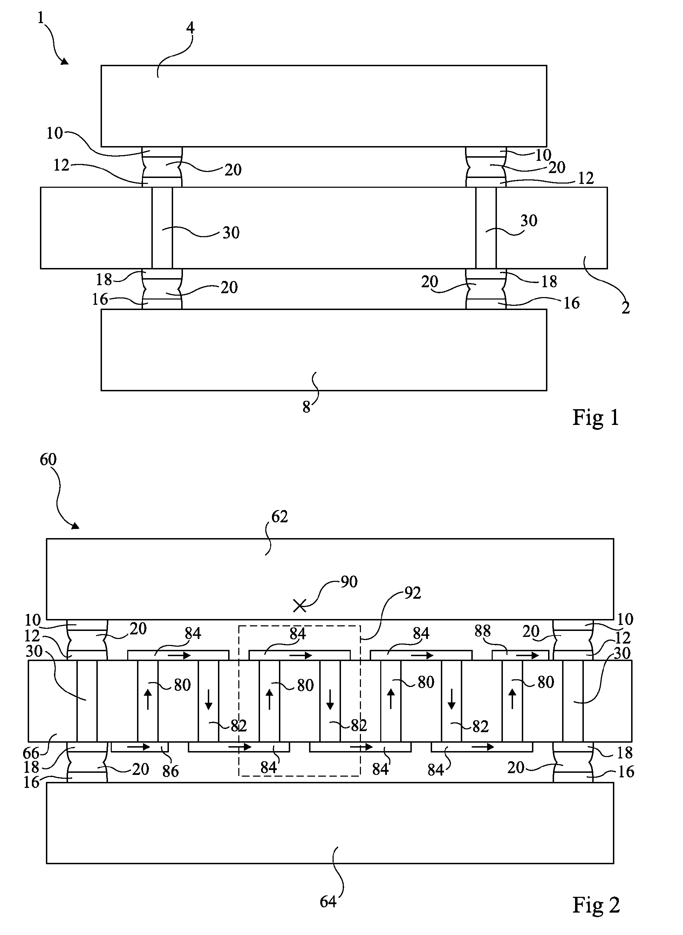

La figure 1 est une vue en coupe schématique représentant un dispositif électronique 1 comprenant une plaque d'interface 2. Des puces électroniques 4 et 8 sont disposées de part et d'autre de la plaque 2. Les puces sont du type à montage en surface. La puce 4 comprend une pluralité de plots de connexion 10. Par souci de clarté, seuls deux plots 10 sont représentés en figure 1. Chacun des plots 10 est destiné à être disposé en regard d'un plot de connexion 12 de la plaque 2. De la même manière, on a représenté sur la puce 8 deux plots de connexion 16 qui sont disposés en regard de deux plots de connexion 18 de la plaque 2. Sur chacun des plots 10, 12, 16 et 18 est disposée une bille de brasure destinée à être brasée avec une bille en regard. Les assemblages de billes sont désignés par la référence 20. Les plots de connexion peuvent être en cuivre et les billes en étain-argent. Les billes ont par exemple un diamètre de 100 micromètres.

Tout autre mode de connexion à montage en surface pourrait être utilisé.

Les plots de connexion 12 et 18 formés de part et d'autre de la plaque 2 sont raccordés électriquement par des vias 30.

Dans une configuration dans laquelle la puce 4 est un microprocesseur et la puce 8 comprend des mémoires, la puce 4 est plus chaude que la puce 8 lorsque le dispositif 1 est en fonctionnement. On parlera ci-après de puce chaude et de puce froide.

Lorsqu'un point chaud se déclare à la surface de la puce 4 en regard de la plaque d'interface 2, le flux thermique diffuse en direction de la plaque qui joue un rôle de répartiteur thermique.

La figure 2 représente un dispositif électronique 60 permettant de transformer une partie de l'énergie thermique émise par une puce chaude en énergie électrique, la puce chaude étant disposée en regard d'une puce froide.

Le dispositif 60 comprend une puce 62 raccordée à une puce 64 par l'intermédiaire d'une plaque d'interface 66. Comme précédemment, la plaque 66 comprend des vias 30 disposés entre des plots 12 et 18. A titre d'exemple, le matériau conducteur des vias peut être du cuivre, du tungstène ou de l'aluminium.

La plaque d'interface 66 comprend également un premier ensemble d'une pluralité d'ouvertures traversantes 80 et un deuxième ensemble d'une pluralité d'ouvertures traversantes 82. Les ouvertures 80 et 82 sont alternées. Le premier matériau remplissant les ouvertures 80 constitue un premier composant d'un couple thermoélectrique. Le second matériau remplissant les ouvertures 82 constitue le second composant complémentaire du couple. Les premier et second matériaux sont distincts et peuvent être compris dans le groupe composé du silicium, du germanium, du cuivre, du tungstène et de l'aluminium. On peut également prévoir des matériaux, tels que le bismuth, le tellerium, le plomb et l'antimoine.

Les couples thermoélectriques sont connectés en série. A la figure 2, deux couples thermoélectriques adjacents, dont chacun est constitué de deux composants complémentaires 80 et 82, sont raccordés électriquement par un élément de connexion 84. Cet élément de connexion est par exemple en cuivre. Les éléments 84 sont disposés de part et d'autre de la plaque 66. Les deux ouvertures 80 disposées à l'extrémité de la plaque 66 sont respectivement reliées à une borne de connexion 86 et à une borne de connexion 88. La borne de connexion 86 assure la connexion entre le composant 80 et un plot de connexion non représenté. Il en est de même pour la borne de connexion 88. Les bornes de connexion 86 et 88 sont par exemple en cuivre.

Chacune des puces 62 et 64 comprend une pluralité de plots de connexion 10, 16 disposés par exemple à la périphérie de chacune des puces. La connexion électrique entre chacune des puces 62 et 64 d'une part et la plaque 66 d'autre part est assurée par montage en surface.

Lorsque le dispositif 60 est en fonctionnement, on considère que la puce 62 est une puce chaude et la puce 64 une puce froide. Il existe donc une différence de température entre la puce 62 et la puce 64. On observe ainsi par effet Seebeck une différence de tension entre les deux bornes de connexion 86 et 88. La différence de tension électrique est directement proportionnelle à la différence de température. Un courant circule alors dans le sens des flèches représentées en figure 2.

Dans une approche locale, lorsqu'un point chaud 90 apparaît à la surface de la puce 62 en regard du couple thermoélectrique 92, on observe par effet Seebeck une différence de tension entre les bornes 84 en regard de la puce 64. Un courant électrique circule dans le couple 92 dans le sens des flèches. De la même manière, chaque couple thermoélectrique peut générer une différence de potentiel s'il est soumis à un gradient de température. Un courant électrique peut alors circuler dans chaque couple thermoélectrique. Les couples thermoélectriques étant montés en série, un courant circule donc dans le sens des flèches représentées à la figure 2.

Le courant électrique ainsi généré peut être récupéré au niveau de la borne de connexion 88. Les bornes de connexion 86 et 88 peuvent par exemple être raccordées à une microbatterie ou à une capacité tampon. Cette énergie stockée peut être utilisée pour alimenter la puce 64 ou des puces extérieures au dispositif électronique 60, pour maintenir par exemple une alimentation pendant des périodes de veille. Ainsi, on peut réduire la consommation électrique globale d'un ensemble de puces électroniques.

La Demanderesse a noté que, pour un dispositif électronique comprenant deux puces dont la taille est de 3 x 3 mm² et dont l'une est par exemple un processeur multimédia pour des applications de téléphones portables, et l'autre a une consommation négligeable, par exemple une puce comprenant uniquement des mémoires, et une plaque d'interface interposée entre les deux puces, on peut générer environ 60 mW pour un écart de température de 30°C entre les deux puces.

Une plaque d'interface disposée entre les deux puces de 3 x 3 mm² peut par exemple comprendre 100000 vias et 15000 couples thermoélectriques. On peut disposer les vias à la périphérie de la plaque 66 et les couples thermoélectriques dans la zone interne délimitée par les vias.

On peut déterminer avant le montage les zones susceptibles de générer des points chauds à la surface du processeur en fonctionnement. On peut donc prévoir de réaliser une plaque d'interface 66 adaptée. Les couples thermoélectriques sont alors disposés dans une zone de la plaque en regard des points chauds susceptibles d'apparaître, une fois la plaque interposée entre les deux puces.

De la même manière, on peut prévoir une plaque d'interface adaptée à être interposée entre des première et deuxième puces chaudes susceptibles de générer chacune plusieurs points chauds. On réalise un ensemble de couples thermoélectriques sur la plaque d'interface en regard de chaque point chaud susceptible d'apparaître sur les puces. Les ensembles adaptés à coopérer avec les points chauds générés par le premier processeur peuvent être connectés en série. Il en est de même pour les ensembles adaptés à coopérer avec les points chauds générés par le second processeur. On veillera à ne pas raccorder en série ces deux ensembles. En effet, on génèrerait une tension de signe opposé entre chacun des ensembles. Leur contribution au courant électrique s'annulerait. Chacun des deux ensembles peut contribuer de manière indépendante à la charge d'une batterie par exemple.

La plaque d'interface 66 peut servir de dispositif de sécurité. Si la tension entre les bornes 86 et 88 est supérieure à une tension de seuil prédéterminée, on peut prévoir de stopper le fonctionnement de la puce chaude.

Le matériau composant la plaque d'interface 66 peut être en silicium ou en polymère. Si le matériau est du silicium haute résistivité (par exemple une résistivité supérieure à 500 ohms.cm, de préférence supérieure à 1000 ohms.cm) ou du polymère, on peut prévoir avantageusement de ne plus isoler par un dépôt d'une couche isolante la plaque 66 des vias 30 et des ouvertures 80, 82 remplies de matériau constituant le thermocouple. Le cas échéant, si le matériau est du silicium faiblement résistif, on prévoira une couche d'isolation électrique entre le silicium et le matériau constituant le via ou un composant d'un couple thermoélectrique.

La plaque d'interface a une épaisseur comprise entre 80 et 200 µm, de préférence entre 100 et 150 µm. Une telle épaisseur de plaque permet de réaliser un dispositif électronique 60 dont l'épaisseur totale est comprise entre 300 et 1000 µm, de préférence entre 500 et 800 µm.

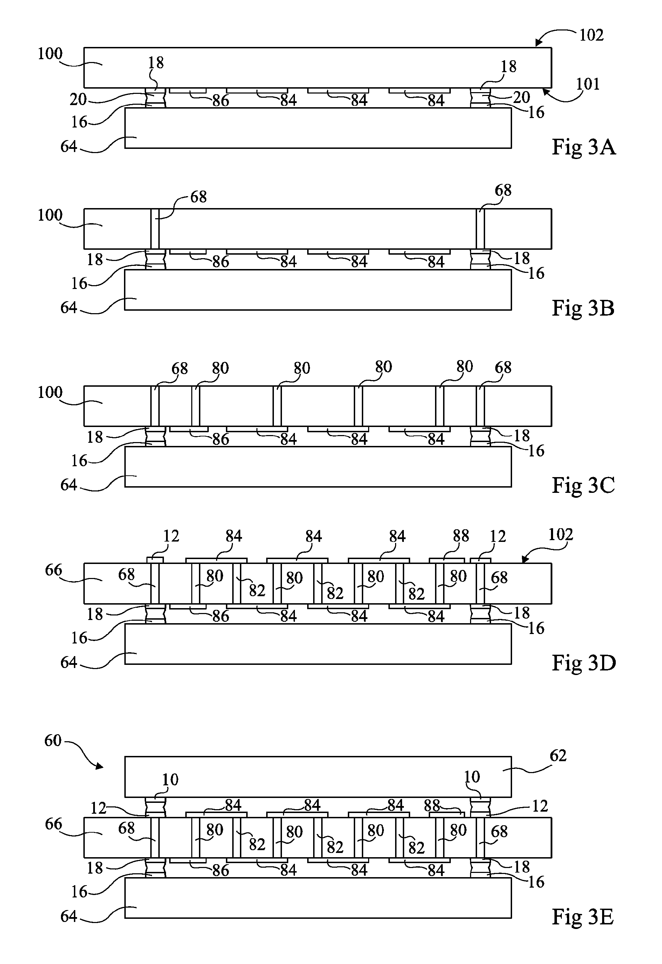

Les figures 3A à 3E illustrent un mode de réalisation d'un procédé de fabrication de la plaque d'interface 66, adapté à de telles épaisseurs.

La figure 3A représente un substrat 100, par exemple en polymère ou en silicium, comprenant des éléments de connexion 84, une borne de connexion 86 ainsi que des plots de connexion 18 déposés sur la face inférieure 101 du substrat. Le substrat 100 est raccordé à une puce 64 par montage en surface.

A l'étape représentée à la figure 3B, on procède à une étape de photolithogravure. Les ouvertures traversantes ainsi obtenues sont ensuite remplies d'un matériau conducteur de manière à former des vias.

A l'étape représentée à la figure 3C, on a procédé à la formation et au remplissage des ouvertures 80 par un matériau constituant un premier composant du couple thermoélectrique.

A l'étape représentée à la figure 3D, on a procédé à la formation et au remplissage des ouvertures traversantes 82 par un matériau constituant le second composant complémentaire du couple thermoélectrique. Sur la face supérieure 102 du substrat 100, on a déposé les plots 12 et les éléments de connexion 84 et 88. On obtient ainsi la plaque d'interface 66 montée sur la puce 64.

A l'étape représentée à la figure 3E, on a connecté la puce 62 et la plaque 66 par l'assemblage de billes 20 interposées entre les plots de connexion 10 et 12. On obtient ainsi le dispositif électronique 60.

En variante au procédé exposé ci-dessus, on peut fixer le substrat 100 à une poignée par exemple en silicium. On réalise alors les étapes 3A à 3E dans cette configuration. On enlève ensuite la poignée et on fixe la puce 64 à la plaque 66 après avoir réalisé les plots 18 et les éléments de connexion 84 et 86.

Les étapes de formation successives des ouvertures 68, 80 et 82 peuvent être réalisées dans un ordre différent.

On peut avantageusement prévoir d'utiliser le même matériau pour réaliser les vias conducteurs 68 et l'un des composants du couple thermoélectrique. Ainsi, on peut supprimer une étape de photo-lithogravure ainsi qu'une étape de remplissage des ouvertures.

Pour le remplissage de chacune des ouvertures traversantes, on peut prévoir d'utiliser un matériau classiquement utilisé dans la fabrication des puces électroniques. Ainsi, on peut bénéficier du savoir faire existant dans les unités de production de semiconducteurs. De tels matériaux peuvent être le silicium, le germanium, le cuivre, le tungstène ou l'aluminium.

Le procédé de fabrication de la plaque d'interface permet de former aisément des couples thermoélectriques connectés en série et disposés entre deux bornes de connexion.

On note la présence de cavités d'air entre chacune des puces 62, 64 et la plaque d'interface 66. Pour combler ces cavités, on peut prévoir un procédé d'encapsulation en injectant un polymère par des seringues.

Des modes de réalisation particuliers de la présente invention ont été décrits. Diverses variantes et modifications apparaîtront à l'homme de l'art. En particulier, si le substrat 100 a une épaisseur supérieure à 100 µm, on peut prévoir de réaliser la plaque d'interface 66 de manière autonome, à savoir sans la rendre solidaire de la puce 64 ou d'une poignée. En effet, le substrat est alors assez rigide pour être manipulé.

Divers modes de réalisation avec diverses variantes ont été décrits ci-dessus. On notera que l'homme de l'art pourra combiner divers éléments de ces divers modes de réalisation et variantes sans faire preuve d'activité inventive.

## Revendications

1. Plaque d'interface (66) adaptée à être montée entre des première et deuxième puces électroniques (62, 64) à montage en surface, cette plaque comprenant une pluralité de premières (30), deuxièmes (80) et troisièmes ouvertures (82) traversantes, les premières ouvertures étant remplies d'un matériau conducteur et étant disposées pour, lors du montage, être en regard de plots (10, 16) des première et deuxième puces, les deuxièmes ouvertures étant remplies d'un deuxième matériau, les troisièmes ouvertures étant remplies d'un troisième matériau, les deuxième et troisième matériaux constituant deux composants complémentaires d'un couple thermoélectrique (92).

2. Plaque selon la revendication 1, dans laquelle le deuxième ou le troisième matériau est identique au matériau conducteur.

3. Plaque selon la revendication 1 ou 2, dans laquelle le deuxième et le troisième matériau sont compris dans le groupe comprenant le silicium, le germanium, le cuivre, le tungstène et l'aluminium.

4. Plaque selon l'une quelconque des revendications précédentes, comprenant au moins un ensemble de premiers couples thermoélectriques coopérant avec la première puce (62), les premiers couples étant connectés en série.

5. Plaque selon la revendication 4, dans laquelle les couples connectés en série sont disposés entre des bornes de connexion (86, 88) configurées pour être couplées à une microbatterie ou à une capacité tampon.

6. Plaque selon la revendication 4 ou 5, comprenant au moins un deuxième ensemble de deuxièmes couples thermoélectriques coopérant avec la deuxième puce (64), les deuxièmes couples étant connectés en série entre eux et n'étant pas connectés en série avec les premiers couples.

7. Plaque selon l'une quelconque des revendications 1 à 6, dans laquelle la plaque est en silicium.

8. Plaque selon la revendication 7, dans laquelle le silicium a une résistivité supérieure à 500 ohms.cm, de préférence supérieure à 1000 ohms.cm.

9. Dispositif électronique (60) comprenant :
une première puce électronique (62) à montage en surface,
une deuxième puce électronique (64) à montage en surface,
une plaque d'interface (66) selon l'une quelconque des revendications 1 à 8 de part et d'autre de laquelle sont montées les première et deuxième puces.
